# EUROPEAN PATENT SPECIFICATION

(11) **EP 2 647 107 B1**
(45) Date of publication and mention of the grant of the patent: **15.04.2015**
(21) Application number: 11813393.3
(22) Date of filing: 05.12.2011
(51) Int. Cl.: H02K 11/00, G01R 33/12, H02K 15/03, H02K 7/18

(54) **METHOD OF DETERMINING THE MAGNETIZATION LEVEL OF PERMANENT MAGNETS OF AN ELECTRIC MACHINE, AND ELECTRIC MACHINE**
VERFAHREN ZUR BESTIMMUNG DES MAGNETISIERUNGSGRADES VON PERMANENTMAGNETEN EINER ELEKTROMASCHINE UND ELEKTROMASCHINE
PROCÉDÉ DE DÉTERMINATION DU NIVEAU DE MAGNÉTISATION D'AIMANTS PERMANENTS D'UNE MACHINE ÉLECTRIQUE ET MACHINE ÉLECTRIQUE

(30) Priority: 03.12.2010 IT MI20102246
(43) Date of publication of application: 09.10.2013
(73) Proprietor: WINDFIN B.V., 2451 VW Leimuiden (NL)
(72) Inventor: KÄSSNER, Thomas, 01187 Dresden (DE); FASOLO, Alessandro, I-39049 Vipiteno (IT); PABST, Otto, I-39037 Rio Di Pusteria (IT)
(74) Representative: Bernotti, Andrea
(86) International application number: PCT/IB2011/055469
(87) International publication number: WO 2012/073225

(56) References cited:
- WO-A1-2008/116463
- US-A1- 2003 055 584

## Description

### TECHNICAL FIELD

The present invention relates to an electric machine.

### BACKGROUND ART

As is known, the efficiency of a rotary, permanent-magnet electric machine, such as a wind turbine alternator, is strongly affected by its magnetization level, which may vary over time. During operation of the machine, the original magnetization condition may be altered, for example, by breakages, exposure to high temperature or intense electromagnetic fields, or other factors.

It is also important to bear in mind that permanent magnets are normally magnetized before the machine is installed, and often even before it is assembled; and assembly and installation may alter magnetization of the permanent magnets, thus greatly affecting performance of the machine by the time it is ready to go into operation.

In fact, it is not unusual for the efficiency of the electric machine to be insufficient or less than predicted.

On the other hand, currently used methods of determining the magnetization of permanent magnets are complicated and expensive, by normally involving dismantling the machine and often also the magnets.

As a result, magnetization of the permanent magnets cannot be checked as often as it should.

Maintenance is therefore not organized properly, the machine is not run to its full potential, and reassembling the magnets involves the same risks as prior to installation of the machine. That is, the risk of altering the magnetization of even perfectly functioning magnets.

WO 2008/116463 discloses an electric machine having a magnetization sensor fixed to the stator and arranged to link a magnetic flux produced by permanent magnets of the rotor. A measuring means detects currents induced in the magnetization sensor in response to passage of the permanent magnets during rotation of the rotor. A processing unit determines the magnetization level of he permanent magnets on the basis of the induced currents detected when the rotor is rotating.

### SUMMARY OF THE INVENTION

It is an object of the present invention to provide an electric machine, designed to eliminate the drawbacks described.

According to one aspect of the present invention, there is provided an electric machine as defined in claim 1.

### BRIEF DESCRIPTION OF THE DRAWINGS

A number of non-limiting embodiments of the present invention will be described by way of example with reference to the accompanying drawings, in which :
Figure 1 shows a partly sectioned side view, with parts removed for clarity, of a wind turbine comprising an electric machine in accordance with one embodiment of the present invention;
Figure 2 shows a larger-scale, partly sectioned side view, with parts removed for clarity, of a detail in Figure 1;
Figure 3 shows a simplified front view of a portion of the Figure 1 electric machine sectioned along line III-III in Figure 2;
Figure 4 shows a simplified block diagram of the Figure 1 electric machine;
Figure 5 shows a simplified block diagram of a component part of the Figure 1 electric machine;
Figure 6 shows a flow chart of steps in a method of determining the magnetization level of permanent magnets of an electric machine in accordance with one embodiment of the present invention;
Figure 7 shows a simplified block diagram of an electric machine in accordance with a different embodiment of the present invention;
Figure 8 shows a simplified block diagram of an electric machine in accordance with another embodiment of the present invention;
Figure 9 shows a simplified front cross section of a portion of an electric machine in accordance with another embodiment of the present invention;
Figure 10 shows an enlarged, three-quarter view in perspective of a detail of the Figure 9 electric machine.

### BEST MODE FOR CARRYING OUT THE INVENTION

In the example embodiments of the invention described below, reference is made to permanent-magnet electric generators used in wind turbines, in which the invention may be used to particular advantage. This, however, shall in no way be construed as a limitation of the invention, which applies to any rotary, permanent-magnet electric machine, particularly synchronous generators, coupled to any type of motor (especially gas, steam, and hydraulic turbines) and electric motors.

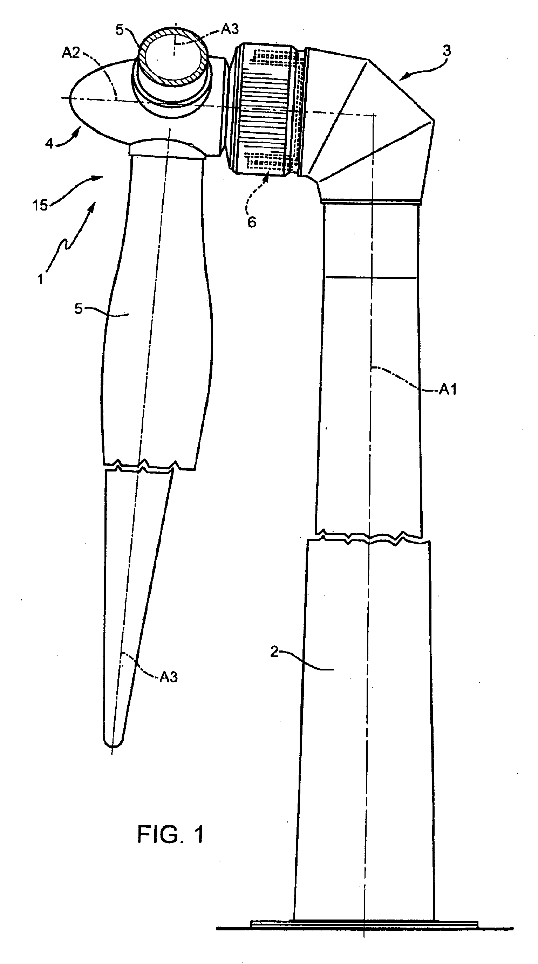

Number 1 in Figure 1 indicates as a whole a wind turbine comprising a pylon 2, a nacelle 3, a hub 4, a plurality of (in the example shown, three) blades 5, and an electric machine 6.

Blades 5 are fitted to hub 4, which in turn is fitted to nacelle 3. Nacelle 3 is fitted to pylon 2 to rotate about an axis A1 and position blades 5 facing the wind; and hub 4 is mounted to rotate about an axis A2 with respect to nacelle 3.

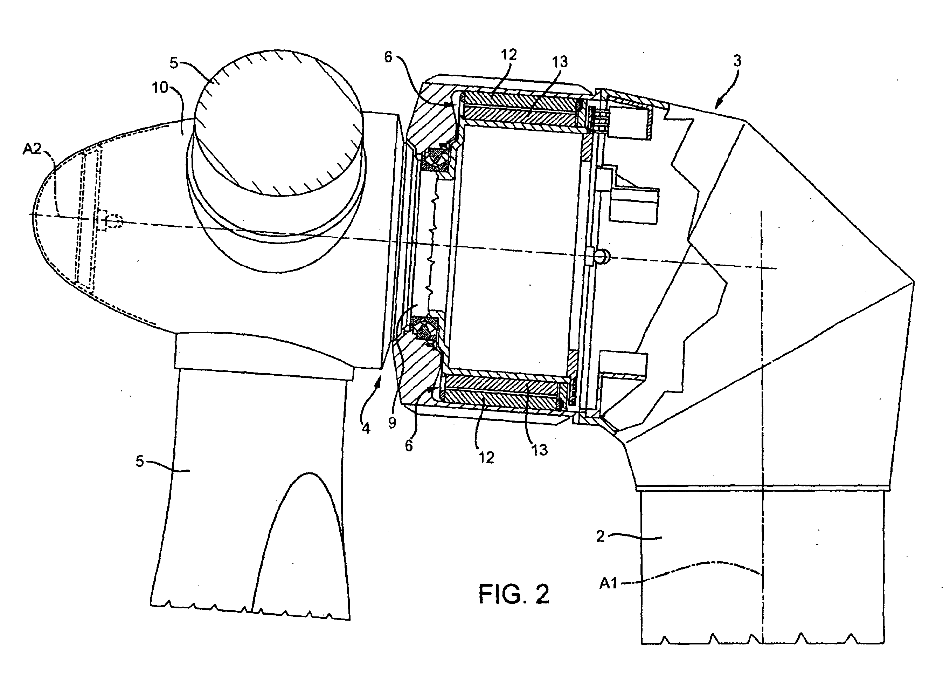

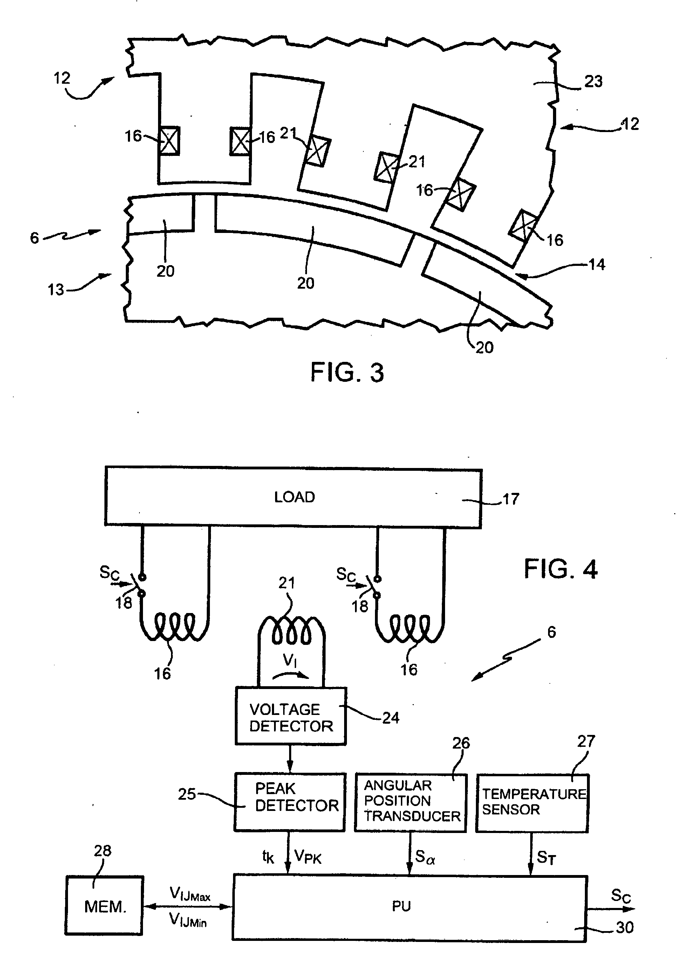

With reference to Figures 2 and 3, hub 4 comprises a hollow shaft 9 and a body 10 connected rigidly to each other. Hollow shaft 9 is fitted to nacelle 3 and, in the embodiment described, is connected directly to electric machine 6.

In the embodiment described, electric machine 6 is a synchronous generator, and comprises a stator 12 and a rotor 13 separated by an annular gap 14. Stator 12 forms a portion of nacelle 3; rotor 13 is fixed directly to hollow shaft 9; and rotor 13, hub 4, and blades 5 define a rotary assembly 15, which rotates with respect to nacelle 3 about axis A2, and is rotated by the wind about axis A2 at an angular speed Ω.

As shown in Figures 3 and 4, stator 12 has a plurality of stator windings 16, each connectable selectively to an electric load 17 by a respective switch 18. When switches 18 are open, the corresponding stator windings 16 are set to an open-circuit condition, isolated from load 17, which may, for example, be an electric power distribution network, to which user devices, not descried in detail, are connected.

Rotor 13 has a plurality of permanent magnets 20, which face stator 12 across gap 14, are designed and arranged to produce a substantially sinusoidal magnetic field along a circle concentric with axis A2 of rotor 13, and may be magnetized radially or tangentially.

A probe winding 21 is housed between stator 12 and rotor 13, is fixed with respect to stator 12, and, in one embodiment, is fitted to a pole piece 22 projecting towards rotor 13 from a casing 23 of stator 12, and located between two adjacent stator windings 16.

Probe winding 21 is oriented to link the magnetic flux generated by permanent magnets 20 passing close to probe winding 21.

Electric machine 6 also comprises a voltage detector 24, a peak detector 25, an angular position transducer 26, a temperature sensor 27, a memory 28, and a preferably non-volatile processing unit 30.

voltage detector 24 is connected to terminals of probe winding 21 to detect an induced voltage V_{I} in response to passage of permanent magnets 20. Given the usual shape and arrangement of permanent magnets 20, induced voltage V₁ is sinusoidal when rotor 13 rotates at constant angular speed Ω.

Peak detector 25 is connected to voltage detector 24 to determine peak values V_{PK} and corresponding peak instants t_{K} of induced voltage V_{I} at each half-wave. Depending on the design of electric machine 6, peak values V_{PK} of induced voltage V_{I} are caused by the magnetic field generated by one or a pair of permanent magnets 20. For the sake of simplicity, unless otherwise stated, reference is made in the following description to peak values V_{PK} of induced voltage V_{I} caused by the magnetic field generated by one permanent magnet 20, it being understood, however, that the same also applies to peak values V_{PK} of induced voltage V_{I} caused by the magnetic field generated by a pair of permanent magnets 20.

Angular position transducer 26, which, in the embodiment described, is an absolute encoder, determines the angular position α of rotor 13 with respect to a reference angular position α_{REF}, and supplies a corresponding angular position signal S_{α} to processing unit 30.

Temperature sensor 27 is located close to rotor 13, in an angular position substantially corresponding to probe winding 21, and supplies processing unit 30 with a temperature signal S_{T} indicating a temperature T of rotor 13. Temperature sensor 27 may, for example, be a thermoresistive sensor or a thermocouple; and, in one embodiment not shown, temperature sensors are also installed on the rotor, close to respective permanent magnets.

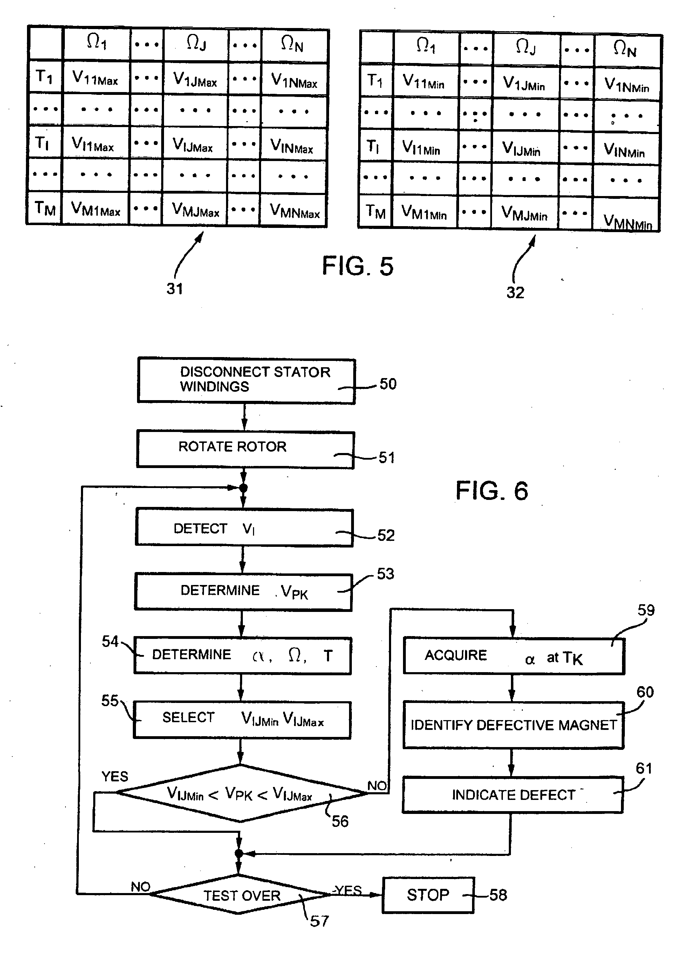

Memory 28 stores maximum values V_{JKMax} and minimum values V_{JKMin} of induced voltage V_{I} as a function of the temperature T and angular speed Ω of rotor 13 (e.g. organized in tables 31, 32, as shown in Figure 5). Maximum values V_{IJMax} and minimum values V_{IJMin} represent maximum and minimum acceptance thresholds for peak values V_{PK} of induced voltage V_{I} in normal operating conditions. In other words, when the magnetization level of the permanent magnet 20 passing close to probe winding 21 is appropriate, the peak values V_{PK} of induced voltage V_{I} range between maximum value V_{IJMax} and minimum value V_{IJMin} corresponding to the current temperature and angular speed Ω of rotor 13. Conversely, when a peak value V_{PK} of induced voltage V_{I} is below minimum value V_{IJMin} or above maximum value V_{IJMax} in the current temperature and angular speed Ω conditions, a magnetization defect, directly attributable to one or a pair of permanent magnets 20, depending on the structure of rotor 13, is detected. Depending on the structure of rotor 13, it is therefore possible to immediately identify the defective permanent magnet 20 or at least a subset (pair) of permanent magnets 20 including the defective permanent magnet 20.

Processing unit 30 receives angular position signal S_{α} and temperature signal S_{T}, is connected to memory 28 to access tables 31 and 32, and controls switches 18 by means of a control signal S_{c} to connect stator windings 16 to electric load 17, or set stator windings 16 to an open-circuit condition.

To determine the magnetization level of permanent magnets 20, processing unit 30 opens switches 18 to set stator windings 16 to the open-circuit condition and disconnect electric load 17, as shown in Figure 6 (block 50); and rotor 13 is then rotated at preferably constant angular speed Ω (block 51).

With rotor 13 rotating, induced voltage V_{I} is detected (block 52), and its absolute peak values V_{PK} detected by peak detector 25 (block 53).

Using angular position signal S_{α} and temperature signal S_{T}, processing unit 30 determines the angular position α, angular speed Ω, and temperature T of rotor 13 (block 54), and then accesses memory 28 to extract from tables 31 and 32 a maximum value V_{IJMax} and minimum value V_{IJMin} corresponding to angular speed Ω and temperature T (block 55). Maximum value V_{IJMax} and minimum value V_{IJMin} are preferably updated whenever a new peak value V_{PK} of induced voltage V_{I} is determined. In other embodiments, not shown, however, maximum value V_{IJMax} and minimum value V_{IJMin} may be read from memory 28 at a predetermined rate, or only following variations in angular speed Ω and/or temperature T of rotor 13.

Processing unit 30 then compares the last peak value V_{PK} with the maximum value V_{IJMax} and minimum value V_{IJMin} extracted from tables 31 and 32 (block 56).

If the peak value V_{PK} ranges between the selected maximum value V_{IJMax} and minimum value V_{IJMin} (YES output of block 56), processing unit 30 determines whether the magnetization test is completed (block 57), and, if it is (YES output of block 57), terminates the procedure (block 58). The test may be considered completed, for example, after a given time interval or after a given plurality of turns of rotor 13. If the test is not yet completed (NO output of block 57), acquisition of induced voltage V_{I} continues (block 52), and the procedure is repeated as described above up to comparison of the last peak value V_{PK} of induced voltage V_{I} with the maximum value V_{IJMax} and minimum value V_{IJMin} selected from tables 31 and 32.

If the peak value V_{PK} of induced voltage V_{I} is above maximum value V_{IJMax} or below minimum value V_{IJMin} (NO output of block 57), processing unit 30 acquires the angular position α of rotor 13 at a peak instant t_{K} corresponding to the peak value V_{PK} that has failed the test (block 59), and identifies the defective permanent magnet 20 by comparing the current angular position α of rotor 13 and the angular position of probe winding 16 with respect to the axis of rotor 13 (block 60). Finally, processing unit 30 indicates the presence and location of a defective permanent magnet 20 (block 61).

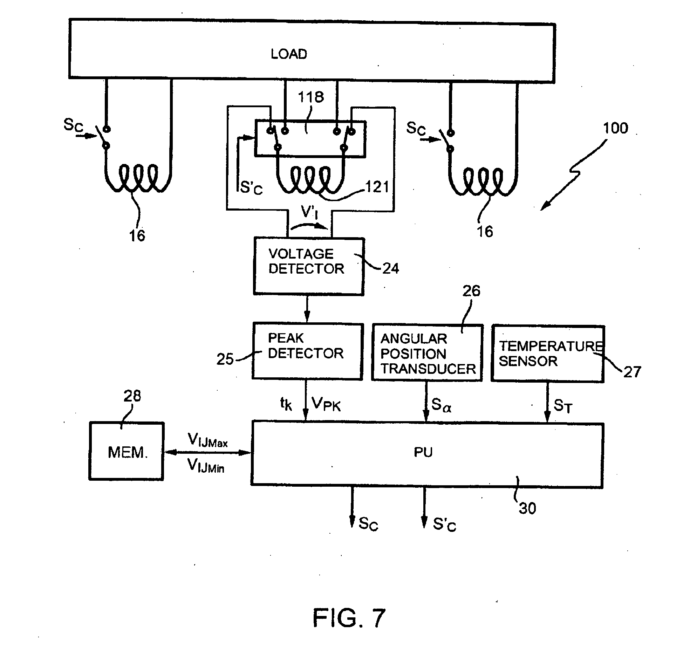

In a different embodiment of the invention, shown in Figure 7, one of stator windings 16 of an electric machine 100 is used as a probe winding and it is indicated with reference numeral 121. In this case, the probe winding 121 is connectable to load 17 or to voltage detector 24 by a selector 118 controlled by processing unit 30 by means of a control signal S_{c}'. During normal operation of electric machine 6, selector 118 connects probe winding 121 to load 17, and probe winding 121 operates as a normal stator winding 16. To test magnetization, processing unit 30 switches selector 118 to connect probe winding 16 to voltage detector 24.

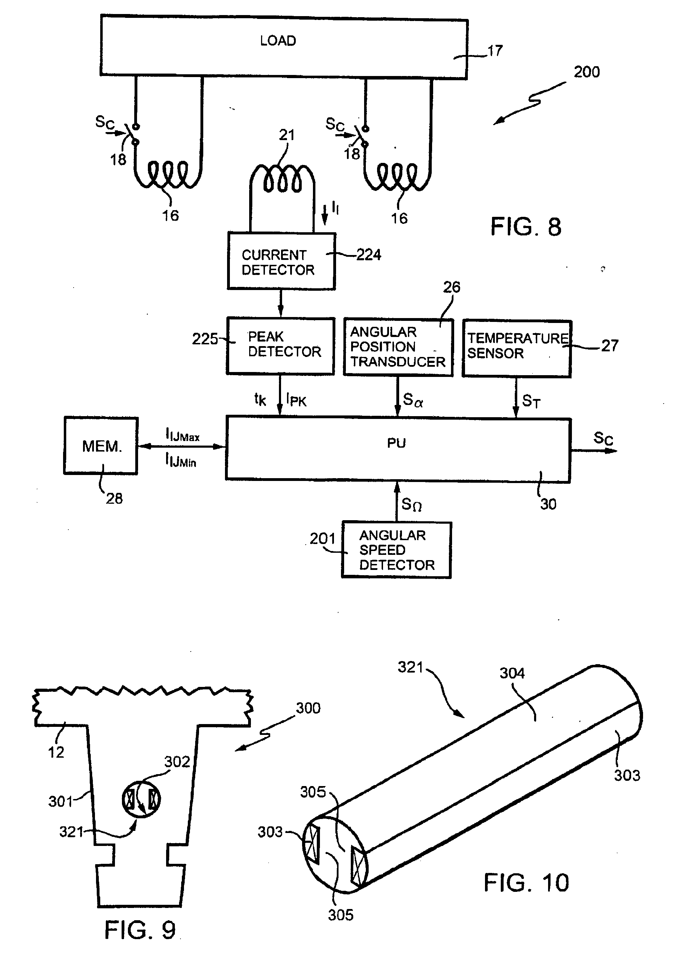

In a further embodiment of the invention, shown in Figure 8, the probe winding 21 of an electric machine 200 is connected to a current detector 224, which detects an induced current I_{I} in probe winding 21 in response to passage of a permanent magnet 20. A peak detector 225 receives induced current I_{I} and determines its peak values I_{PK} at each half-wave. The peak values I_{PK} and corresponding peak instants t_{K} are supplied to processing unit 30. And memory 28 contains maximum values I_{IJMax} and minimum values I_{IJMin} for peak values I_{PK} of induced current I_{I} as a function of the angular speed Ω and temperature T of rotor 13.

In this embodiment, electric machine 200 also comprises an angular speed detector 201, e.g. a gyroscope, accelerometer, or inclinometer, which supplies processing unit 30 with an angular speed signal S_{Ω} indicating the angular speed Ω of rotor 13.

In the Figure 9 and 10 embodiment of the invention, an electric machine 300 comprises a probe winding 321 housed in a through seat 301 formed in a tooth 302 supporting a stator winding 16. More specifically, through seat 301 is a seat for housing a stator tie rod for gripping a portion of stator 12 corresponding to tooth 302. Probe winding 321 is advantageously integrated in a stator tie rod of tooth 302.

Probe winding 321 comprises a conductor 303; and a bar-shaped core 304 made of ferromagnetic material, with a rounded cross section and diametrically opposite longitudinal grooves 305. Conductor 303 is wound longitudinally about core 304 and housed inside grooves 305.

When probe winding 321 is inserted inside tooth 302, its turns are arranged so as to link the magnetic flux generated by rotor 13.

Clearly, changes may be made to the method and electric machine as described herein without, however, departing from the scope of the present invention as defined in the accompanying Claims.

In particular, more than one probe winding may be used in the same electric machine, and different types of probe windings may be used simultaneously.

## Claims

1. An electric machine comprising :
a stator (12) having a plurality of stator windings (16);
a rotor (13) having a plurality of permanent magnets (20);
a probe winding (21; 121; 321) fixed with respect to the stator (12) and located close to the rotor (13) to link a magnetic flux produced by at least one of the permanent magnets (20);
a drive member (4, 5, 9, 10) for rotating the rotor (13) at an angular speed (Ω);
detecting means (24; 224) for detecting an induced electric quantity (V_{I}; I_{I}) at terminals of the probe winding (21; 121; 321) in response to passage of the permanent magnets (20) close to the probe winding (21; 121; 321); and
a processing unit (30) configured to determine a magnetization level of the permanent magnets (20) on the basis of the induced electric quantity (V_{I}; I_{I}) detected when the rotor (13) is rotating;
**characterized by** switching means (18) controllable to alternatively connect the stator windings (16) to external electric equipment, and set the stator windings (16) to an open-circuit condition;
wherein the processing unit (30) is connected to the switching means (18), and is also configured to set the stator windings (16) to an open-circuit condition, and to determine the magnetization level of the permanent magnets (20) on the basis of the induced electric quantity (V_{I}; I_{I}) detected when the rotor (13) is rotating with the stator windings (16) in an open-circuit condition.

2. An electric machine as claimed in Claim 1, wherein the probe winding (321) is housed in a seat (301) formed in a tooth (302) of the stator (12), and comprises :
a bar-shaped core (304) with opposite longitudinal grooves (305); and
a conductor (303) wound about the core (304) and housed in the longitudinal grooves (305).

3. An electric machine as claimed in any one of Claims 1 or 2, wherein the probe winding (321) is integrated in a stator tie rod.

4. An electric machine as claimed in any one of Claims 1 to 3, and comprising an angular position transducer (26) coupled to the processing unit (30) to supply an angular position signal (S_{α}) indicative of an angular position (α) of the rotor (13); and wherein the processing unit (30) is configured to determine an angular speed (Ω) of the rotor (13) on the basis of the angular position signal (S_{α}).

5. An electric machine as claimed in any one of Claims 1 to 3, and comprising an angular speed detecting device (201) coupled to the processing unit (30) to supply an angular speed signal (S_{Ω}) indicative of an angular speed (Ω) of the rotor (13).

6. An electric machine as claimed in Claim 4 or 5, and comprising a memory module (28) storing lower threshold values (V_{IJMin}; I_{IJMin}) and upper threshold values (V_{IJMax}; I_{IJMax}) of the induced electric quantity (V_{I}; I_{I}) as a function of the angular speed (Q) of the rotor (13).

7. An electric machine as claimed in any one of Claims 1 to 5, and comprising a temperature sensor (27) for supplying a temperature signal (S_{T}) indicative of a temperature (T) of the rotor (13).

8. An electric machine as claimed in Claim 7, and comprising a memory module (28) storing lower threshold values (V_{IJMin}; I_{IJMin}) and upper threshold values (V_{IJMax}; I_{IJMax}) of the induced electric quantity (V_{I}; I_{I}) as a function of the temperature of the rotor (13).

## Patentansprüche

1. Eine elektrische Maschine umfassend:
ein Stator (12) mit einer Vielzahl an Statorwindungen (16);
ein Rotor (13) mit einer Vielzahl an Permanentmagneten (20);
eine Sondenwindung (21; 121; 321) bezüglich des Stator (12) befestigt und nahe dem Rotor (13) lokalisiert um einen von zumindest einem der Permanentmagneten (20) produzierten magnetischen Fluss zu verlinken;
ein Antriebsteil (4, 5, 9, 10) zum Rotieren des Rotors (13) mit einer Winkelgeschwindigkeit (Ω);
Detektiermittel (24; 224) zum detektieren einer induzierten elektrischen Größe (V_{I}; I_{I}) an Endstellen der Sondenwindung (21; 121; 321) in Antwort auf ein Passieren der Permanentmagnete (20) nahe an der Sondenwindung (21; 121; 321); und
eine Prozesseinheit (30) konfiguriert um einen Magnetisierungsgrad der Permanentmagnete (20) auf der Basis der induzierten elektrischen Größe (V_{I}; I_{I}), detektiert wenn der Rotor (13) rotiert, zu bestimmen;
**gekennzeichnet durch** Schaltmittel (18) steuer- bzw. regelbar um alternativ die Statorwindungen (16) mit äußerer elektrischer Ausstattung zu verbinden und die Statorwindungen (16) in einen Offenkreiszustand (engl. open-circuit condition) zu setzen;
wobei die Prozesseinheit (30) mit den Schaltmitteln (18) verbunden ist und auch konfiguriert ist, um die Statorwindungen (16) in einen Offenkreiszustand zu setzen und um den Magnetisierungsgrad der Permanentmagnete (20) auf der Basis der induzierten elektrischen Größe (V_{I}; I_{I}) zu bestimmen, welcher detektiert wird wenn der Rotor (13) während eines Offenkreiszustand rotiert.

2. Eine elektrische Maschine wie in Anspruch 1 beansprucht, wobei die Sondenwindung (321) in einem Sitz (301) untergebracht ist, welcher in einem Zahn bzw. einer Zinke bzw. einer Zacke (302) des Stators (12) geformt ist und umfassend:
einen stabförmigen Kern (304) mit entgegengesetzten longitudinalen Rillen (305); und
einen um den Kern (304) gewickelten und in den longitudinalen Rillen (305) untergebrachten Leiter (303).

3. Eine elektrische Maschine wie in irgendeinem der Ansprüche 1 oder 2 beansprucht, wobei die Sondenwindung (321) in einem Statorzuganker bzw. einer Statorzugstange (engl. stator tie rod) integriert ist.

4. Eine elektrische Maschine wie in irgendeinem der Ansprüche 1 bis 3 beansprucht und umfassend einen Drehstellungswandler (26) gekoppelt an der Prozesseinheit (30), um ein Drehstellungssignal (S_{α}), welches für eine Drehstellung (α) des Rotors (13)bezeichnend ist bereitzustellen; und wobei die Prozesseinheit (30) konfiguriert ist, um eine Winkelgeschwindigkeit (Ω) des Rotors (13) auf der Basis des Drehstellungssignals (S_{α}) zu bestimmen.

5. Eine elektrische Maschine wie in irgendeinem der Ansprüche 1 bis 3 beansprucht und umfassend eine Winkelgeschwindigkeitsdetektiervorrichtung (201) gekoppelt an die Prozesseinheit (30), um ein Winkelgeschwindigkeitssignal (S_{Ω}), welche eine Winkelgeschwindigkeit (Ω) des Rotors (13) bezeichnet, bereitzustellen.

6. Eine elektrische Maschine wie in irgendeinem der Ansprüche 4 oder 5 beansprucht und umfassend ein Speichermodul (28), welches untere Schwellenwertwerte (V_{IJMin}; I_{IJMin}) und obere Schwellenwertwerte (V_{IJMax}; I_{IJMax}) der induzierten elektrischen Göße (V_{I}; I_{I}) als eine Funktion der Winkelgeschwindigkeit (Ω) des Rotors (13) speichert.

7. Eine elektrische Maschine wie in irgendeinem der Ansprüche 1 bis 5 beansprucht und umfassend einen Temperatursensor (27) zum Bereitstellen eines Temperatursignals (S_{T}), welches eine Temperatur (T) des Rotors (13) bezeichnet.

8. Eine elektrische Maschine wie in Anspruch 7 beansprucht und umfassend ein Speichermodul (28), welches untere Schwellenwertwerte (V_{IJMin}; I_{IJMin}) und obere Schwellenwertwerte (V_{IJMax}; I_{IJMax}) der induzierten elektrischen Göße (V_{I}; I_{I}) als eine Funktion der Temperatur des Rotors (13) speichert.

## Revendications

1. Machine électrique comprenant :
un stator (12) comportant une pluralité d'enroulements de stator (16) ;
un rotor (13) comportant une pluralité d'aimants permanents (20) ;
un enroulement explorateur (21 ; 121 ; 321) fixe par rapport au stator (12) et situé à proximité du rotor (13) pour guider un flux magnétique généré par au moins un des aimants permanents (20) ;
un élément d'entraînement (4, 5, 9, 10) servant à faire tourner le rotor (13) à une vitesse angulaire (Ω) ;
des moyens de détection (24 ; 224) servant à détecter une grandeur électrique induite (V_{I} ; I_{I}) aux bornes de l'enroulement explorateur (21 ; 121 ; 321) en réponse au passage des aimants permanents (20) à proximité de l'enroulement explorateur (21 ; 121 ; 321) ; et
une unité de traitement (30) configurée pour déterminer un niveau d'aimantation des aimants permanents (20) sur la base de la grandeur électrique induite (V_{I} ; I_{I}) détectée lorsque le rotor (13) est en rotation ;
**caractérisée par** des moyens de commutation (18) pouvant être commandés pour connecter alternativement les enroulements de stator (16) à l'équipement électrique externe, et placer les enroulements de stator (16) dans un état de circuit ouvert ;
l'unité de traitement (30) étant reliée aux moyens de commutation (18), et étant également configurée pour placer les enroulements de stator (16) dans un état de circuit ouvert, et pour déterminer le niveau d'aimantation des aimants permanents (20) sur la base de la grandeur électrique induite (V_{I} ; I_{I}) détectée lorsque le rotor (13) tourne avec les enroulements de stator (16) dans un état de circuit ouvert.

2. Machine électrique selon la revendication 1, dans laquelle l'enroulement explorateur (321) est logé dans un siège (301) formé dans une dent (302) du stator (12), et comprend :
un noyau (304) en forme de barre comportant des gorges longitudinales (305) opposées ; et
un conducteur (303) enroulé autour du noyau (304) et logé dans les gorges longitudinales (305).

3. Machine électrique selon l'une quelconque des revendications 1 ou 2, dans laquelle l'enroulement explorateur (321) est intégré dans une barre de raccordement de stator.

4. Machine électrique selon l'une quelconque des revendications 1 à 3, comprenant un transducteur de position angulaire (26) couplé à l'unité de traitement (30) pour délivrer un signal de position angulaire (S_{α}) indiquant une position angulaire (α) du rotor (13) ; l'unité de traitement (30) étant configurée pour déterminer une vitesse angulaire (Ω) du rotor (13) sur la base du signal de position angulaire (S_{α}).

5. Machine électrique selon l'une quelconque des revendications 1 à 3, comprenant un dispositif de détection de vitesse angulaire (201) couplé à l'unité de traitement (30) pour délivrer un signal de vitesse angulaire (S_{Ω}) indicatif d'une vitesse angulaire (Ω) du rotor (13).

6. Machine électrique selon la revendication 4 ou 5, comprenant un module de mémoire (28) mémorisant des valeurs de seuil inférieures (V_{IJMin} ; I_{IJMin}) et des valeurs de seuil supérieures (V_{IJMax} ; I_{IJMax}) de la grandeur électrique induite (V_{I} ; I_{I}) en fonction de la vitesse angulaire (Ω) du rotor (13).

7. Machine électrique selon l'une quelconque des revendications 1 à 5, comportant un capteur de température (27) destiné à délivrer un signal de température (S_{T}) indicatif d'une température (T) du rotor (13).

8. Machine électrique selon la revendication 7, comprenant un module de mémoire (28) mémorisant des valeurs de seuil inférieures (V_{IJMin} ; I_{IJMin}) et des valeurs de seuil supérieures (V_{IJMax} ; I_{IJMax}) de la grandeur électrique induite (V_{I} ; I_{I}) en fonction de la température du rotor (13).
